# EUROPÄISCHE PATENTSCHRIFT

(11) **EP 2 909 694 B1**
(45) Veröffentlichungstag und Bekanntmachung des Hinweises auf die Patenterteilung: **09.10.2019**
(21) Anmeldenummer: 13776498.1
(22) Anmeldetag: 14.10.2013
(51) Int. Cl.: G06F 1/20, G06F 1/18

(54) **ANORDNUNG FÜR EIN COMPUTERSYSTEM SOWIE EIN COMPUTERSYSTEM**
ARRANGEMENT FOR A COMPUTER SYSTEM AND COMPUTER SYSTEM
AGENCEMENT POUR UN SYSTÈME INFORMATIQUE AINSI QU'UN SYSTÈME INFORMATIQUE

(30) Priorität: 16.10.2012 DE 102012109853
(43) Veröffentlichungstag der Anmeldung: 26.08.2015
(73) Patentinhaber: Fujitsu Limited, Kawasaki-shi Kanagawa 211-8588 (JP)
(72) Erfinder: TREFFLER, Roland, 86167 Augsburg (DE); TROLLMANN, Peter, 86199 Augsburg (DE); PILZ, Erich, 86343 Königsbrunn (DE); SCHERER, August, 86424 Dinkelscherben (DE)
(74) Vertreter: Epping - Hermann - Fischer
(86) Internationale Anmeldenummer: PCT/EP2013/071426
(87) Internationale Veröffentlichungsnummer: WO 2014/060354

(56) Entgegenhaltungen:
- US-A- 6 113 485
- US-A1- 2004 095 723
- US-A1- 2012 008 276
- US-B1- 6 678 157

## Beschreibung

Die vorliegende Erfindung betrifft eine Anordnung für ein Computersystem, welche eine Wärme erzeugende Erweiterungskarte aufweist. Des Weiteren betrifft die Erfindung ein Computersystem, insbesondere ein Desktop- oder Towersystem.

Zur Kühlung von elektronischen Komponenten eines Computersystems werden häufig Kühlkörper eingesetzt, die in einen möglichst guten thermischen Kontakt mit den elektronischen Komponenten, beispielsweise Einsteckkarten, gebracht werden. Solche Kühlkörper zeichnen sich in der Regel durch eine große Oberfläche aus und geben über Konvektion Wärme an die Umgebungsluft ab.

Aus der US 2004/0095723 A1 sind eine interne Kühlkörpervorrichtung und ein Kühlsystem innerhalb eines Personalcomputers bekannt.

Aus der US 6,113,485 A ist ein System zum Kühlen integrierter Schaltkreise und insbesondere zur Verwendung von Kühlluftführungen alleine oder in Kombination mit Kühllüftern bekannt.

Moderne Einsteckkarten, wie beispielsweise sogenannte "High-End-Computingkarten", zeichnen sich durch leistungsstarke Prozessoreinheiten, in der Regel Grafikprozessoren mit tausenden Recheneinheiten, aus. Besonders rechenintensive Teile von Softwareanwendungen werden zur schnelleren Berechnung auf diese Einsteckkarten ausgelagert, um einen zentralen Prozessor zu entlasten. Die High-End-Computingkarten sind für den Einsatz in 1U- oder 2U-Serverrack-Systemen vorgesehen. Diese Serverrack-Systeme verfügen über spezielle Kühlsysteme, welche die in Folge der hohen Rechenleistung entstehende, große Verlustwärme der High-End-Computingkarten abführen. Vor allem aufgrund der Tatsache, dass solche Einsteckkarten heutzutage nur noch mit einer passiven Kühlung angeboten werden, sind die High-End-Computingkarten für den Einsatz in einem Desktop- oder Towersystem allerdings nicht oder nur bedingt geeignet. In der Praxis hat sich gezeigt, dass ein Kühlluftstrom eines konventionellen Desktop- oder Towersystems nicht ausreicht, um High-End-Computingkarten ausreichend zu kühlen, so dass diese überhitzt werden. In Folge dessen kann es zu einer Fehlfunktion oder einem völligen Ausfall der High-End-Computingkarten kommen.

Es ist eine Aufgabe der Erfindung, eine Anordnung für den Einsatz von High-End-Computingkarten in einem Desktop- oder Towersystem zu beschreiben.

Die genannte Aufgabe wird erfindungsgemäß durch eine Anordnung gemäß Anspruch 1 beschrieben. Die Kühlvorrichtung weist wenigstens einen Lüfter und einen quaderförmig ausgebildeten Hohlkörper mit einer ersten Öffnung und einer der ersten Öffnung gegenüberliegenden zweiten Öffnung zum Kühlen der Erweiterungskarte auf. Der Hohlkörper ist mit der ersten Öffnung an die Erweiterungskarte angeordnet. Des Weiteren ist der wenigstens eine Lüfter im Bereich der zweiten Öffnung an dem Hohlkörper angeordnet oder wird von dem Hohlkörper mittels der zweiten Öffnung zumindest teilweise umgeben. Der wenigstens eine Lüfter ist dazu eingerichtet, einen Luftstrom durch den Hohlkörper zum Kühlen der Erweiterungskarte zu erzeugen.

Die Anordnung gemäß dem ersten Aspekt der Erfindung sieht vor, dass die Wärme erzeugende Erweiterungskarte mit Hilfe der zusätzlichen Kühlvorrichtung gekühlt wird. Im Bereich der ersten Öffnung ist der Hohlkörper der Kühlvorrichtung an der Erweiterungskarte angeordnet. Dabei kann der Hohlkörper mechanisch, beispielsweise durch Verschrauben, an der Erweiterungskarte festgelegt sein. Im Bereich der zweiten Öffnung des Hohlkörpers ist der Lüfter zumindest teilweise von dem Hohlkörper umgegeben oder ist an dem Hohlkörper angeordnet. Dadurch ist es möglich, dass ein von dem Lüfter erzeugter Kühlluftstrom gezielt auf die Erweiterungskarte gelenkt wird, direkt durch die Erweiterungskarte strömt und die Abwärme der Erweiterungskarte abführt. Durch diese Anordnung ist es beispielsweise möglich, die nur mit einem Kühlkörper ausgestatteten High-End-Computingkarten auch in einem Desktop- oder Towersystem ausreichend zu kühlen.

Gemäß einer möglichen Ausgestaltung der Erfindung ist der Hohlkörper quaderförmig ausgebildet, wobei bevorzugt die erste Öffnung gegenüber der zweiten Öffnung liegt. Dadurch wird ein geringer Strömungswiderstand für den vom Lüfter erzeugten Luftstrom erreicht, so dass der Erweiterungskarte die Kühlluft gut zugeführt werden kann.

Gemäß einer möglichen Ausgestaltung der Erfindung umgibt der Hohlkörper im Bereich der ersten Öffnung die Erweiterungskarte zumindest teilweise. Dadurch ist es möglich, dass ein von dem Lüfter erzeugter Kühlluftstrom besonders gezielt und direkt durch die Erweiterungskarte strömen und diese kühlen kann.

Gemäß einer weiteren, möglichen Ausgestaltung der Erfindung weist der Hohlkörper wenigstens eine dritte Öffnung in dem von dem Hohlkörper umgebenen Bereich der Erweiterungskarte zum Freilegen eines Anschlusses der Erweiterungskarte auf. Durch die Vorsehung der dritten Öffnung ist es beispielsweise möglich, die Erweiterungskarte über den freigelegten Anschluss mit Strom zu versorgen.

Gemäß einer weiteren möglichen Ausgestaltung der Erfindung besteht der Hohlkörper im Wesentlichen aus einem Kunststoffwerkstoff. Damit ist eine kostengünstige Herstellung des Hohlkörpers möglich.

Gemäß einer weiteren, möglichen Ausgestaltung der Erfindung weist die Erweiterungskarte einen Temperatursensor für die Steuerung des wenigstens einen Lüfters auf. Über den Temperatursensor kann die Temperatur der Erweiterungskarte gemessen werden, wodurch abhängig von der Temperatur der wenigstens eine Lüfter gesteuert werden kann. Je nach gemessenem Temperaturwert kann beispielsweise die Strömungsgeschwindigkeit des erzeugten Luftstroms angepasst werden.

Gemäß einer weiteren, möglichen Ausgestaltung weist der wenigstens eine Lüfter einen Temperatursensor für die Steuerung des wenigstens einen Lüfters auf. Über den Temperatursensor kann die Temperatur der Abwärme der Erweiterungskarte gemessen werden, wodurch abhängig von der gemessenen Temperatur der wenigstens eine Lüfter analog zu der oben beschriebenen Ausgestaltung gesteuert werden kann.

Gemäß einer weiteren, möglichen Ausgestaltung ist im Bereich der Erweiterungskarte ein Temperatursensor für die Steuerung des wenigstens einen Lüfters angeordnet. Hierbei kann die Temperatur der Erweiterungskarte gemessen werden, wobei die gemessenen Temperaturwerte analog zu den oben beschriebenen Ausgestaltungen für die Steuerung des wenigstens einen Lüfters verwendet werden können. Dabei kann die Temperatur der Erweiterungskarte unabhängig von einer Strömungsrichtung des Luftstromes, beispielsweise durch Saugen oder Ausblasen von Luft mittels des wenigstens einen Lüfters, gemessen werden.

Gemäß einer weiteren, möglichen Ausgestaltung der Erfindung ist an einer Außenseite des Hohlkörpers wenigstens ein Halteelement zur Aufnahme in einem Kartenhalter angebracht.

Ein solcher Kartenhalter, welcher in der Regel zum Halten von langen Erweiterungskarten dient, befindet sich beispielsweise in einem Computergehäuse und hält das Halteelement des Hohlkörpers. Damit ist die Kühlvorrichtung in dem Computergehäuse sicher festgelegt.

Gemäß einem zweiten Aspekt der Erfindung wird ein Computersystem, insbesondere ein Desktop- oder Towersystem, beschrieben. Das Computersystem weist ein Gehäuse und einen innerhalb des Gehäuses angeordneten Kartenhalter auf. Des Weiteren weist das Gehäuse eine in dem Gehäuse angeordnete Hauptplatine mit wenigstens einer Steckverbindung auf. Das Computersystem weist weiter eine Anordnung gemäß dem erstem Aspekt der Erfindung mit einer Erweiterungskarte und einer Kühlvorrichtung auf, wobei die Erweiterungskarte und die Kühlvorrichtung innerhalb des Gehäuses angeordnet sind. Die Erweiterungskarte ist mittels der wenigstens einen Steckverbindung mit der Hauptplatine verbunden. An einer Außenseite des Hohlkörpers ist wenigstens ein Halteelement angebracht. Die Kühlvorrichtung ist mittels des wenigstens einen Halteelements des Hohlkörpers in dem Kartenhalter gehalten.

Das Computersystem gemäß dem zweiten Aspekt der Erfindung weist im Wesentlichen die vorgenannten Vorteile auf. Zusätzlich erweist es sich als vorteilhaft, dass durch die Anordnung gemäß dem ersten Aspekt der Erfindung innerhalb des Gehäuses des Computersystems keine baulichen Veränderungen am Gehäuse oder einer Komponente des Computersystems vorgenommen werden müssen.

Weitere vorteilhafte Ausgestaltungen der Erfindung sind in der nachfolgenden ausführlichen Beschreibung von Ausführungsbeispielen sowie den abhängigen Patentansprüchen offenbart.

Die Erfindung wird nachfolgend anhand der Ausführungsbeispiele unter Bezugnahme auf die angehängten Figuren beschrieben. In den Figuren werden gleichartige Komponenten unterschiedlicher Ausführungsbeispiele mit gleichem Bezugszeichen versehen.

In den Figuren zeigen:
- Figur 1: eine perspektivische Ansicht eines Computersystems gemäß einem ersten Ausführungsbeispiel und
- Figur 2: eine Draufsicht einer Anordnung gemäß einem zweiten Ausführungsbeispiel.

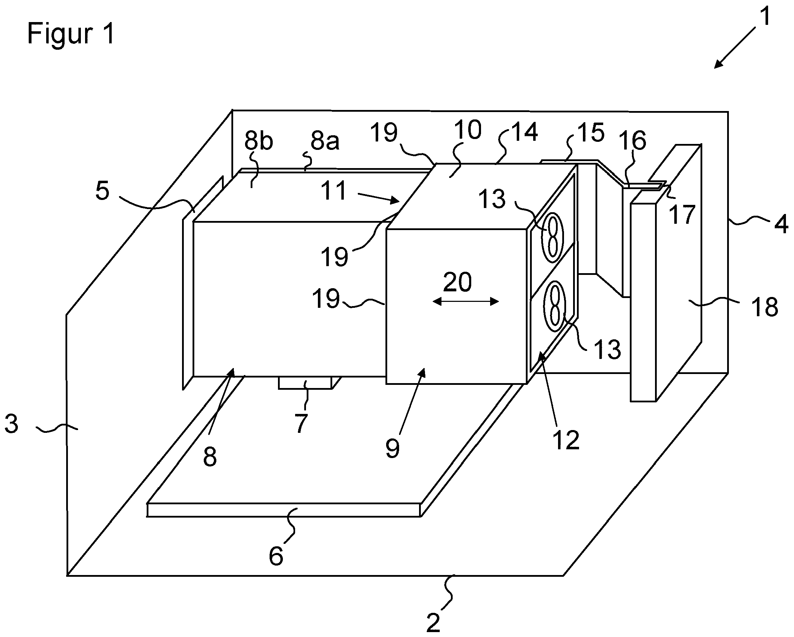

Figur 1 zeigt ein Computersystem 1, beispielsweise ein Desktop- oder Towersystem, gemäß einem ersten Ausführungsbeispiel der Erfindung, wobei aus Gründen der Übersichtlichkeit nur eine Gehäuseunterseite 2, eine erste Gehäuseseite 3 und eine zweite Gehäuseseite 4 eines Gehäuses dargestellt sind. Die erste Gehäuseseite 3 weist ein Slotfeld 5 zum Anbringen von Erweiterungskarten auf. In dem Gehäuse ist eine Hauptplatine 6, beispielsweise ein Mainboard, mit darauf angeordneter Steckverbindung 7 angeordnet. Weiter ist in dem Gehäuse eine Erweiterungskarte 8 angeordnet, die mittels der Steckverbindung 7 mit der Hauptplatine 6 verbunden ist. Die Erweiterungskarte 8 ist weiterhin an dem Slotfeld 5 angebracht, beispielsweise über einen Slotwinkel (nicht dargestellt).

Das Computersystem 1 weist eine Kühlvorrichtung 9 mit einem Hohlkörper 10 auf. Der Hohlkörper 10 weist eine erste Öffnung 11 und eine zweite Öffnung 12 auf, die der ersten Öffnung 11 gegenüber liegt. Im Bereich der ersten Öffnung 11 umgibt der Hohlkörper 10 zumindest teilweise die Erweiterungskarte 8. Im Bereich der zweiten Öffnung 12 sind innerhalb des Hohlkörpers 10 zwei Lüfter 13 angeordnet. In der Regel weisen die beiden Lüfter 13 eine quadratische Form auf und sind deshalb übereinander angeordnet, um dem in der Regel länglichen Format der Erweiterungskarte 8 bzw. des Hohlkörpers 10 Rechnung zu tragen. Die beiden Lüfter 13 können beispielsweise in den Hohlkörper 10 eingesteckt, eingeklemmt, eingeklebt oder mit dem Hohlkörper 10 verschraubt sein. An einer Außenseite 14 des Hohlkörpers 10 ist ein Halteelement 15 angeordnet, dessen Ende 16 in einer Aufnahmeöffnung 17 eines Kartenhalters 18 gehalten wird. Der Kartenhalter 18 ist ebenfalls innerhalb des Gehäuses des Computersystems 1 angeordnet und kann an einer Gehäuseseite angeordnet sein. In der Regel stellt der Kartenhalter eine Standart-Komponente eines Computersystems 1 zum Halten standardisierter Erweiterungskarten 8 dar.

Die Erweiterungskarte 8 kann beispielsweise eine High-End-Computingkarte sein und ebenso wie die Steckverbindung 7 einen Anschluss gemäß einem der folgenden Standards aufweisen: AGP, PCI, PCI-Express, Low Profile PCI und Vesa Local Bus. Die Erweiterungskarte 8 weist eine Karte 8a und ein Kartengehäuse 8b auf, in welches die Karte 8a gekapselt ist. Die Erweiterungskarte 8, die eine hohe Verlustwärme erzeugt, ist nur mit einer passiven Kühlung ausgestattet. Dies kann beispielsweise ein lamellenartiger Kühlkörper oder ein sogenannter "Heat-Spreader", also eine Metallplatte mit großer Oberfläche, sein, welche Wärme durch Konvektion in das Innere des Kartengehäuses 8b bzw. das Gehäuse des Computersystems 1 abgeben (nicht dargestellt). Der Heat-Spreader ist beispielsweise innerhalb des Kartengehäuses 8b auf einem auf der Karte 8a angeordneten Speicher- oder Prozessorbaustein angeordnet.

Mit Hilfe der Kühlvorrichtung 9 kann die Erweiterungskarte 8 ausreichend gekühlt werden. Hierzu erzeugen die Lüfter 13 einen Kühlluftstrom, welcher in dem von dem Hohlkörper 10 umgebenen Bereich der Erweiterungskarte 8 in das Kartengehäuse 8b eintritt. Der von den Lüftern 13 erzeugte Luftstrom nimmt die von der Erweiterungskarte 8 produzierte Verlustwärme, beispielsweise die Wärme des Heat-Spreaders, auf. Die von der Kühlluft aufgenommene Wärme tritt entsprechend dem Luftstrom durch die Erweiterungskarte 8 über einen Slotwinkel (nicht dargestellt) am Slotfeld 5 aus. Der Slotwinkel, der auch als Slotblech bezeichnet wird, weist zu diesem Zweck beispielsweise eine Vielzahl von Öffnungen für den Luftaustritt auf. Somit können Erweiterungskarten 8, welche ursprünglich für den Einsatz in 1U- oder 2U-Serverrack-Systemen bestimmt sind, auch in einem herkömmlichen Desktop- oder Towersystem verwendet werden.

Wie beschrieben tritt der von den Lüftern 13 erzeugte Luftstrom im Bereich der ersten Öffnung 11 in das Kartengehäuse 8b der Erweiterungskarte 8 ein und strömt entsprechend der Luftstromrichtung durch die Erweiterungskarte 8 zur Aufnahme von Wärme. Es ist allerdings auch denkbar, dass der Hohlkörper 10 derart dimensioniert ist, dass der erzeugte Luftstrom im Bereich der ersten Öffnung 11 Wärme durch Umströmen der Erweiterungskarte 8 aufnimmt und aus einer, mehrerer oder allen Seiten 19 des Hohlkörpers 10 ins Innere des Gehäuses des Computersystems austritt. Im Inneren des Gehäuses kann die Wärme beispielsweise über Systemlüfter abgesaugt und abgeführt werden.

Die Tatsache, dass der Hohlkörper 10 die Erweiterungskarte 8 umgibt, bewirkt, dass der Hohlkörper 10 einen Längenausgleich für verschiedene Kartenlängen der Erweiterungskarte 8 gewährleisten kann. Der Hohlkörper 10 ist in einer Erstreckungsrichtung gemäß dem Doppelpfeil 20 derart dimensioniert, dass Erweiterungskarten 8 mit unterschiedlicher Länge in einer Richtung gemäß dem Doppelpfeil 20 von dem Hohlkörper 10 umgeben werden können. Damit ist für unterschiedlich lange Erweiterungskarten 8 eine ausreichende Kühlung durch die Kühlvorrichtung 9 gewährleistet, da der Kühlluftstrom der Lüfter 13 in die Erweiterungskarte 8 eintreten kann. Dabei muss die Kühlvorrichtung nicht konstruktiv verändert werden.

Zur Steuerung der Lüfter 13, beispielsweise der Strömungsgeschwindigkeit des von den Lüftern 13 erzeugten Luftstroms, kann ein Regelkreis mit einem Regler und einer Regelstrecke vorgesehen sein. Der Regelkreis erhält dabei Temperaturwerte eines Temperatursensors, der beispielsweise auf der Erweiterungskarte 8 angeordnet ist. In einer möglichen Alternative kann der Regelkreis auch Werte eines Temperatursensors der Hauptplatine 6 oder eines im Bereich der Erweiterungskarte 8 angeordneten Temperatursensors erhalten. Das Auslesen des Temperatursensors erfolgt gemäß den beiden letztgenannten Fällen über den Systemmanagement-Bus.

Beispielsweise ist der Temperatursensor ein Regelwiderstand, beispielsweise ein NTC-Widerstand, und elektrisch mit einem der beiden Lüfter 13 verbunden. Der Temperatursensor ist auf der Erweiterungskarte 8 oder im Bereich der Erweiterungskarte 8 angeordnet und kann nun ausgewertet und zur Steuerung des einen Lüfters 13 verwendet werden. Die Auswertung kann dabei von dem einen Lüfter 13 selbst vorgenommen werden. Alternativ können auch zwei Temperatursensoren beziehungsweise Regelwiderstände vorgesehen sein, welche jeweils mit einem der beiden Lüfter 13 elektrisch verbunden sind und zur Steuerung der beiden Lüfter 13 verwendet werden können. Beispielsweise kann in einem Lastfall, das heißt bei Zunahme einer Abwärmetemperatur der Erweiterungskarte 8, zuerst nur ein Lüfter 13 eine Lüfterdrehzahl erhöhen. Bei weiter steigenden Abwärmetemperaturen kann dann der zweite Lüfter 13 seine Lüfterdrehzahl entsprechend erhöhen. Somit ist es möglich, im Wesentlichen leise und effektiv die Erweiterungskarte 8 zu kühlen. Zudem können die beiden Lüfter 13 unabhängig voneinander betrieben werden, so dass bei einem Defekt nur eines Lüfters 13 unter erhöhter Lüfterdrehzahl und erhöhtem Geräusch des weiteren Lüfters 13 die Erweiterungskarte 8 dennoch betrieben werden kann. Somit kann auf diese Weise dem Anwender ein Defekt eines Lüfters 13 signalisiert werden, ohne dass es möglicherweise zu einem Datenverlust kommt.

Alternativ kann die Steuerung der Lüfter 13 beispielsweise über das Systemboard oder eine zusätzliche Steuerkarte (nicht dargestellt) erfolgen, welche parallel zu der Erweiterungskarte 8 angeordnet in einer weiteren Steckverbindung 7 eingesteckt ist. Das Systemboard oder die Steuerkarte liest einen Temperatursensor, beispielsweise den im Bereich der Erweiterungskarte 8 angeordneten Temperatursensor, oder über den Systemmanagement-Bus (SM-BUS) oder den I²C-Bus einen in der Erweiterungskarte 8 vorhandenen Temperatursensor aus und ist mit den Lüftern 13 zur Steuerung dieser verbunden.

In einer weiteren Alternative können beide oder einer der beiden Lüfter 13 einen Temperatursensor aufweisen, deren gemessene Werte dem Regelkreis zugeführt werden.

Die Lüfter 13 sind beispielsweise an einem Netzteil im Gehäuse des Computersystems 1 angeschlossen und werden von diesem Netzteil entweder direkt oder mittelbar über Controller der Hauptplatine 6 mit elektrischer Spannung versorgt (nicht dargestellt).

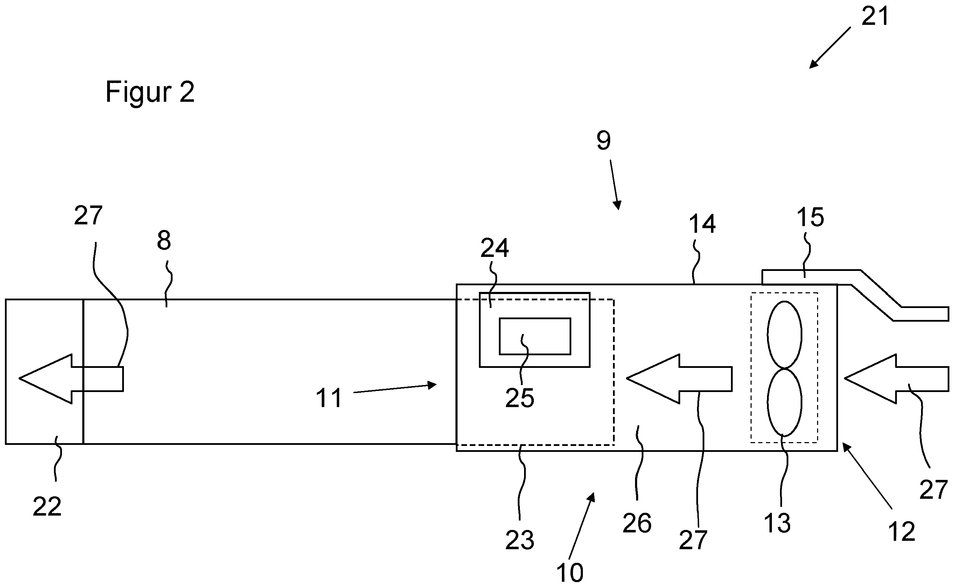

Figur 2 zeigt die Draufsicht einer Anordnung 21 mit einer Erweiterungskarte 8 und einer Kühlvorrichtung 9, wie sie beispielsweise in einem Computersystem 1 gemäß dem ersten Ausführungsbeispiel anhand der Figur 1 vorzufinden ist. Die bereits aus der Figur 1 bekannten Merkmale der Erweiterungskarte 8 und der Kühlvorrichtung 9 werden nicht erneut beschrieben.

An der Erweiterungskarte 8 ist ein Slotwinkel 22 zum Anbringen der Erweiterungskarte 8 in einem Slotfeld angeordnet. Der Hohlkörper 10 der Kühlvorrichtung 9 umgibt die Erweiterungskarte 8 in einem Bereich 23 (gestrichelt dargestellt). Der Hohlkörper 10 weist eine dritte Öffnung 24 auf, die einen Anschluss 25 der Erweiterungskarte 8 freilegt. Über den Anschluss 25 kann die Erweiterungskarte 8 beispielsweise an eine zusätzliche Stromversorgungsleitung angeschlossen werden. Innerhalb des Hohlkörpers 10 ist zwischen dem Lüfter 13 und dem Bereich 23 der Erweiterungskarte 8 ein Hohlraum 26 ausgebildet. Je nachdem wie weit die Erweiterungskarte 8 in den Hohlkörper 10 hineinragt, ist der Hohlraum 26 kleiner oder größer ausgebildet. Der Hohlkörper 10 gleicht dadurch unterschiedliche Längen der Erweiterungskarte 8 aus, wie bereits anhand des Ausführungsbeispieles gemäß der Figur 1 beschrieben wurde.

Die Lüfter 13 saugen auf der Seite der zweiten Öffnung 12 Kühlluft gemäß einer Pfeilrichtung 27 an und führen diese in den Hohlkörper 10. Dadurch entsteht ein Luftstrom, der in Pfeilrichtung 27 in dem Bereich 23 in die Erweiterungskarte 8 eindringt und diese durchströmt. Durch die Durchströmung der Erweiterungskarte 8 nimmt der Luftstrom die Verlust- bzw. Abwärme der Erweiterungskarte 8 auf und führt diese im Bereich des Slotwinkels 22 aus der Erweiterungskarte 8 ab. Hierzu kann der Slotwinkel 22 Öffnungen, beispielsweise Bohrungen oder Schlitze, aufweisen.

In einem alternativen, nicht dargestellten Ausführungsbeispiel kann der Lüfter 13 auch einen Luftstrom erzeugen, der entgegengesetzt zu der Pfeilrichtung 27 verläuft. Der Luftstrom nimmt dabei ebenfalls Wärme von der Erweiterungskarte 8 auf und führt diese über die zweite Öffnung 12 ins Innere des Computergehäuses ab. In einem solchen Ausführungsbeispiel ist es beispielsweise möglich, dass beide oder einer der beiden Lüfter 13 einen Temperatursensor aufweisen, deren gemessene Werte dem oben beschriebenen Regelkreis zugeführt werden.

In einem weiteren alternativen, nicht dargestellten Ausführungsbeispiel kann die Erweiterungskarte 8 einen in dem Bereich 23 angeordneten weiteren Anschluss, beispielsweise für eine weitere, zusätzliche Stromzufuhr, besitzen. Der weitere Anschluss kann dabei über die erste Öffnung 11, die zweite Öffnung 12 oder die dritte Öffnung 24 zugänglich sein.

In einer alternativen, nicht gezeigten Ausführungsform kann der Hohlkörper 10 auch an der Erweiterungskarte 8 angeordnet sein, ohne diese zu umgeben. Dabei ist der Hohlkörper 10 an der Erweiterungskarte 8 mechanisch festgelegt beziehungsweise an die Erweiterungskarte 8 angeflanscht, beispielsweise mittels Verschrauben oder einer anderen Verbindungstechnik. Beispielsweise können hierzu bereits vorhandene Bohrungen der Erweiterungskarte 8, an welche ein Halteelement 15 angebracht werden könnte, verwendet werden. Alternativ können auch eine oder mehrere andere Bohrungen verwendet werden. Dadurch ist der Hohlkörper 10 berührend an der Erweiterungskarte 8 angeordnet.

Mit Hilfe einer solchen Kühlvorrichtung 9 kann die Erweiterungskarte 8 ebenfalls ausreichend gekühlt werden. Der von den Lüftern 13 erzeugte Kühlluftstrom tritt in dem Bereich der Erweiterungskarte 8, in welchem der Hohlkörper 10 an der Erweiterungskarte 8 festgelegt ist, in das Kartengehäuse 8b ein. Alternativ können die Lüfter 13 auch einen Kühlluftstrom durch Absaugen von Luft aus der Erweiterungskarte 8 beziehungsweise aus dem Kartengehäuse 8b erzeugen. Der von den Lüftern 13 erzeugte Kühlluftstrom nimmt die von der Erweiterungskarte 8 produzierte Verlustwärme auf und ermöglicht ein effizientes und gezieltes Kühlen der Erweiterungskarte 8 in einem Desktop- oder Towersystem.

Die in den beschriebenen Ausführungsbeispielen dargelegten Merkmale eines Computersystems bzw. einer Anordnung für ein Computersystem können auf verschiedener Weise miteinander kombiniert werden, um die jeweils genannten Vorteile und/oder Funktionen zu verwirklichen.

### Bezugszeichenliste

- 1: Computersystem
- 2: Unterseite
- 3: Gehäuseseite
- 4: Gehäuseseite
- 5: Slotfeld
- 6: Hauptplatine
- 7: Steckverbindung
- 8: Erweiterungskarte
- 8a: Karte
- 8b: Kartengehäuse
- 9: Kühlvorrichtung
- 10: Hohlkörper
- 11: erste Öffnung
- 12: zweite Öffnung
- 13: Lüfter
- 14: Außenseite
- 15: Halteelement
- 16: Ende
- 17: Aufnahmeöffnung
- 18: Kartenhalter
- 19: Seite
- 20: Doppelpfeil
- 21: Anordnung
- 22: Slotwinkel
- 23: umgebener Bereich
- 24: dritte Öffnung
- 25: Anschluss
- 26: Hohlraum
- 27: Pfeil

## Patentansprüche

1. Anordnung (21) für ein Computersystem (1), aufweisend
- eine Wärme erzeugende Erweiterungskarte (8), wobei die Erweiterungskarte eine Karte (8a) und ein Kartengehäuse (8b) aufweist, in welchem die Karte gekapselt ist;
- einen an der Erweiterungskarte angebrachten Slotwinkel zum Anbringen an einem Slotfeld;
- eine Kühlvorrichtung (9) mit wenigstens einem Lüfter (13) und einem quaderförmig ausgebildeten Hohlkörper (10) mit einer ersten Öffnung (11) und einer der ersten Öffnung (11) gegenüberliegenden zweiten Öffnung (12) zum Kühlen der Erweiterungskarte (8); wobei
- der Hohlkörper (10) mit der ersten Öffnung (11) an die Erweiterungskarte (8) angeordnet ist;
- der wenigstens eine Lüfter (13) im Bereich der zweiten Öffnung (12) an dem Hohlkörper (10) angeordnet ist oder von dem Hohlkörper (10) mittels der zweiten Öffnung (12) zumindest teilweise umgeben wird; und
- der wenigstens eine Lüfter (13) dazu eingerichtet ist, einen Luftstrom durch den Hohlkörper (10) zum Kühlen der Erweiterungskarte (8) zu erzeugen;
- der Slotwinkel Öffnungen aufweist zum Einlassen oder Auslassen des Luftstroms;

2. Anordnung (21) nach Anspruch 1, bei welcher der Hohlkörper (10) im Bereich der ersten Öffnung (11) die Erweiterungskarte (8) zumindest teilweise umgibt.

3. Anordnung (21) nach Anspruch 2, bei welcher der Hohlkörper (10) wenigstens eine dritte Öffnung (24) in dem von dem Hohlkörper (10) umgebenen Bereich (23) der Erweiterungskarte (8) zum Freilegen eines Anschlusses (25) der Erweiterungskarte (8) aufweist.

4. Anordnung (21) nach einem der Ansprüche 1 bis 3, bei welcher der Hohlkörper (10) im Wesentlichen aus einem Kunststoffwerkstoff besteht.

5. Anordnung (21) nach einem der Ansprüche 1 bis 4, bei welcher die Erweiterungskarte (8) einen Temperatursensor für die Steuerung des wenigstens einen Lüfters (13) aufweist.

6. Anordnung (21) nach einem der Ansprüche 1 bis 4, bei welcher der wenigstens eine Lüfter (13) einen Temperatursensor für die Steuerung des wenigstens einen Lüfters (13) aufweist.

7. Anordnung (21) nach einem der Ansprüche 1 bis 4, welche einen im Bereich der Erweiterungskarte angeordneten Temperatursensor für die Steuerung des wenigstens einen Lüfters (13) aufweist.

8. Anordnung (21) nach einem der Ansprüche 1 bis 7, bei welcher an einer Außenseite (14) des Hohlkörpers (10) wenigstens ein Halteelement (15) zur Aufnahme in einem Kartenhalter (18) angebracht ist.

9. Anordnung (21) nach einem der Ansprüche 1 bis 8, bei welcher die Erweiterungskarte (8) eine Computing-Karte ist.

10. Computersystem (1), insbesondere ein Desktop- oder Towersystem, aufweisend:
- ein Gehäuse;
- einen innerhalb des Gehäuses angeordneter Kartenhalter (18); und
- eine in dem Gehäuse angeordnete Hauptplatine (6) mit wenigstens einer Steckverbindung (7); und
- eine Anordnung (21) nach einem der Ansprüche 1 bis 9 mit einer Erweiterungskarte (8) und einer Kühlvorrichtung (9); wobei
- die Erweiterungskarte (8) und die Kühlvorrichtung (9) innerhalb des Gehäuses angeordnet sind;
- die Erweiterungskarte (8) mittels der wenigstens einen Steckverbindung (7) mit der Hauptplatine (6) verbunden ist;
- an einer Außenseite (14) des Hohlkörpers (10) wenigstens ein Halteelement (15) angebracht ist; und
- die Kühlvorrichtung (9) mittels des wenigstens einen Halteelements (14) des Hohlkörpers (10) in dem Kartenhalter (18) gehalten ist.

11. Computersystem (1) nach Anspruch 10, bei welchem die Hauptplatine (6) wenigstens einen Temperatursensor für die Steuerung des wenigstens einen Lüfters (13) aufweist.

## Claims

1. Assembly (21) for a computer system (1), comprising
- a heat-generating expansion card (8), wherein the expansion card comprises a card (8a) and a card housing (8b) in which the card is encapsulated;
- a slot bracket which is attached to the expansion card and is intended for attachment to a slot panel;
- a cooling device (9) which comprises at least one fan (13) and a cuboid hollow body (10) having a first opening (11) and a second opening (12) located opposite the first opening (11) and for cooling the expansion card (8); wherein
- the hollow body (10) is arranged with the first opening (11) towards the expansion card (8);
- the at least one fan (13) is arranged on the hollow body (10) in the region of the second opening (12) or is at least partially surrounded by the hollow body (10) by means of the second opening (12); and
- the at least one fan (13) is configured to generate an airflow through the hollow body (10) for cooling the expansion card (8);
- the slot bracket comprises openings for the admission or exit of the airflow.

2. Assembly (21) according to claim 1, wherein the hollow body (10) surrounds the expansion card (8), at least in part, in the region of the first opening (11).

3. Assembly (21) according to claim 2, wherein the hollow body (10) comprises at least one third opening (24) in the region (23) of the expansion card (8) surrounded by the hollow body (10), for exposing a port (25) of the expansion card (8).

4. Assembly (21) according to any of claims 1 to 3, wherein the hollow body (10) consists substantially of a plastics material.

5. Assembly (21) according to any of claims 1 to 4, wherein the expansion card (8) comprises a temperature sensor for controlling the at least one fan (13).

6. Assembly (21) according to any of claims 1 to 4, wherein the at least one fan (13) comprises a temperature sensor for controlling the at least one fan (13).

7. Assembly (21) according to any of claims 1 to 4, comprising a temperature sensor, arranged in the region of the expansion card, for controlling the at least one fan (13).

8. Assembly (21) according to any of claims 1 to 7, wherein at least one retaining element (15), intended to be received in a card holder (18), is attached to an outer face (14) of the hollow body (10).

9. Assembly (21) according to any of claims 1 to 8, wherein the expansion card (8) is a computing card.

10. Computer system (1), in particular a desktop or tower system, comprising:
- a housing;
- a card holder (18) arranged inside the housing; and
- a motherboard (6) arranged in the housing, with at least one plug connection (7); and
- an assembly (21) according to any of claims 1 to 9 comprising an expansion card (8) and a cooling device (9); wherein
- the expansion card (8) and the cooling device (9) are arranged inside the housing;
- the expansion card (8) is connected to the motherboard (6) by means of the at least one plug connection (7);
- at least one retaining element (15) is attached to an outer face (14) of the hollow body (10); and
- the cooling device (9) is retained in the card holder (18) by means of the at least one retaining element (14) of the hollow body (10).

11. Computer system (1) according to claim 10, wherein the motherboard (6) comprises at least one temperature sensor for controlling the at least one fan (13).

## Revendications

1. Ensemble (21) pour un système informatique (1), présentant
- une carte d'extension (8) générant de la chaleur, dans lequel la carte d'extension présente une carte (8a) et un boîtier de carte (8b), dans lequel la carte est encapsulée ;
- un cornière fendue installée au niveau de la carte d'extension, destinée à être installée au niveau d'un panneau à fente ;
- un dispositif de refroidissement (9) avec au moins un ventilateur (13) et un corps creux (10) réalisé de manière à présenter une forme parallélépipédique avec une première ouverture (11) et une deuxième ouverture (12), faisant face à la première ouverture (11), servant à refroidir la carte d'extension (8) ; dans lequel
- le corps creux (10), avec la première ouverture (11) est disposé vers la carte d'extension (8) ;
- l'au moins un ventilateur (13) est disposé dans la zone de la deuxième ouverture (12) au niveau du corps creux (10) ou est entouré au moins en partie par le corps creux (10) au moyen de la deuxième ouverture (12) ; et
- l'au moins un ventilateur (13) est configuré pour générer un flux d'air à travers le corps creux (10) pour refroidir la carte d'extension (8) ;
- la cornière fendue présente des ouvertures servant à faire entrer ou sortir le flux d'air.

2. Ensemble (21) selon la revendication 1, dans lequel le corps creux (10) entoure au moins en partie dans la zone de la première ouverture (11) la carte d'extension (8).

3. Ensemble (21) selon la revendication 2, dans lequel le corps creux (10) présente au moins une troisième ouverture (24) dans la zone (23), entourée par le corps creux (10), de la carte d'extension (8) pour mettre à découvert une connexion (25) de la carte d'extension (8).

4. Ensemble (21) selon l'une quelconque des revendications 1 à 3, dans lequel le corps creux (10) consiste sensiblement en un matériau synthétique.

5. Ensemble (21) selon l'une quelconque des revendications 1 à 4, dans lequel la carte d'extension (8) présente un capteur de température pour la commande de l'au moins un ventilateur (13).

6. Ensemble (21) selon l'une quelconque des revendications 1 à 4, dans lequel l'au moins un ventilateur (13) présente un capteur de température pour la commande de l'au moins un ventilateur (13).

7. Ensemble (21) selon l'une quelconque des revendications 1 à 4, lequel présente un capteur de température disposé dans la zone de la carte d'extension pour la commande de l'au moins un ventilateur (13).

8. Ensemble (21) selon l'une quelconque des revendications 1 à 7, dans lequel au moins un élément de maintien (15) destiné à être logé dans un support de carte (18) est fixé au niveau d'un côté extérieur (14) du corps creux (10).

9. Ensemble (21) selon l'une quelconque des revendications 1 à 8, dans lequel la carte d'extension (8) est une carte informatique.

10. Système informatique (1), en particulier système de bureau ou de tour, présentant :
- un boîtier ;
- un support de carte (18) disposé à l'intérieur du boîtier ; et
- une carte mère (6) disposée dans le boîtier, avec au moins une connexion à fiche (7) ; et
- un ensemble (21) selon l'une quelconque des revendications 1 à 9 avec une carte d'extension (8) et un dispositif de refroidissement (9) ; dans lequel
- la carte d'extension (8) et le dispositif de refroidissement (9) sont disposés à l'intérieur du boîtier ;
- la carte d'extension (8) est reliée à la carte mère (6) au moyen de l'au moins une connexion à fiche (7) ;
- au moins un élément de maintien (15) est installé au niveau d'un côté extérieur (14) du corps creux (10) ; et
- le dispositif de refroidissement (9) est maintenu dans le support de carte (18) au moyen de l'au moins un élément de maintien (14) du corps creux (10).

11. Système informatique (1) selon la revendication 10, dans lequel la carte mère (6) présente au moins un capteur de température pour la commande de l'au moins un ventilateur (13).
